# FASCICULE DE BREVET EUROPEEN

(11) **EP 0 857 013 B1**
(45) Date de publication et mention de la délivrance du brevet: **26.10.2005**
(21) Numéro de dépôt: 98500031.4
(22) Date de dépôt: 04.02.1998
(51) Int. Cl.: H05K 13/04

(54) **Tête d'insertion de fiches de différentes longeurs**
Zufuhreinrichtung für Anschlussbeinchen verschiedener Länge
Insertion head for leads of different length

(30) Priorité: 04.02.1997 ES 9700218
(43) Date de publication de la demande: 05.08.1998
(73) Titulaire: MECANISMOS AUXILIARES INDUSTRIALES S.A. M.A.I.S.A., E-43800 Valls, Tarragona (ES); Construcciones Mecanicas Jose Lazpiur, S.A., 43800 Valls, Tarragona (ES)
(72) Inventeur: Altes Puig, Josep, 43800 Valls (Tarragona) (ES)
(74) Mandataire: Primo de Rivera y Urquijo, Jose A.

(56) Documents cités:
- EP-A- 0 240 835
- ES-A- 2 024 121
- FR-A- 2 466 936
- US-A- 4 268 739

## Description

La présente sollicitude de patente d'invention consiste, conformément aux indications de l'énoncé, en une "TÊTE D'INSERTION DE FICHES DE DIFFÉRENTES LONGUEURS", dont les nouvelles caractéristiques de construction, conformation et conception remplissent la mission pour laquelle elle a été spécifiquement projetée, avec un maximum de sécurité et d'efficacité.

Il existe sur le marché, et elles peuvent donc être considérées comme un état de la technique, des machines à insérer dont la principale mission se fonde sur une série d'éléments parmi lesquels se trouve la tête d'insertion, procédant à cette fonction, celle d'insertion, à partir d'un système d'alimentation de composants électriques ou électroniques, tels que des fiches, ponts, languettes, douilles et similaires. Ces machines à insérer incorporent, entre autres éléments, une table de coordonnées qui se déplace aux quatre points cardinaux selon des axes X et Y, celle-ci incorporant un plateau giratoire situé sur le propre circuit imprimé, lequel se solidarise avec le plateau au moment où la tête procède à l'insertion des composants de ce circuit imprimé pour procéder ensuite à l'opération d'insertion proprement dite.

La nature des têtes d'insertion, quant à leur conception constructive, est en général déterminée par le type d'éléments, qu'ils soient électriques, électroniques ou similaires, qui doivent être insérés dans la plaque de circuit imprimé, c'est-à-dire que la nature physique et géométrique de ces éléments détermine dans une grande mesure la conception spécifique de chaque tête, ce qui fait que sa conception spécifique varie énormément, bien que la plupart de celles qui se trouvent sur le marché ait la même fonction, en fonction desdites configurations des éléments à intégrer dans le circuit imprimé.

Dans la patente d'invention ES-A-2 024 121 est décrite et revendiquée une tête automatique pour l'insertion de pattes sur des plaques de circuit imprimé, lequel effectue quatre mouvements en marge du contexte de la machine à insérer, par le biais de la réalisation d'une première fonction d'alimentation au travers d'un rouleau de fil de fer ou similaire, suivie de la coupe, puis d'une troisième opération de rapprochement ou d'adaptation des pattes, une fois effectuée la coupe à la forme pertinente, pour finalement réaliser l'opération d'insertion proprement dite.

L'objet de la présente invention est de perfectionner les têtes d'insertion du type de celles qui sont décrites dans la patente susmentionnée et d'autres similaires, dans le sens de simplifier le nombre d'éléments qui permettent le fonctionnement de celle-ci et, d'autre part, permettre, sans qu'il soit besoin de changer tout ou partie de la tête, d'insérer des fiches de différentes longueurs, ce qui fait que l'on réalise une considérable économie de temps, ainsi qu'une augmentation du rendement spécifique de la machine à insérer, ce qui, en combinaison avec des machines comprenant entre autres avantages celui de pouvoir être alimentées avec des circuits imprimés de différentes dimensions, d'augmenter encore davantage le rendement spécifique de tout l'ensemble, en incorporant à la machine à insérer en soi, dotée d'un système d'alimentation en continu, le rendement spécifique susmentionné.

Les simplifications constructives sur ce que l'on considère comme l'état de la technique, consistent essentiellement à exécuter la tâche d'insertion avec une tête dotée uniquement de deux cylindres hydrauliques ou pneumatiques ce qui fait que la complexité, la construction et le prix final de la tête d'insertion résultent bien moindres et, par conséquent, il n'est pas besoin d'effectuer autant de réglages pour sa mise au point. La tête d'insertion selon l'invention est defini par les caractéristiques de la revendication 1. Fondamentalement, la tête d'insertion est composée de jeux de rouleaux redresseurs, situés à 90º, l'un derrière l'autre, qui permettent conjointement d'aligner et de redresser le fil de fer, lequel, à la suite de cette opération, est introduit dans le corps central de la tête où il est entraîné, selon une solution conventionnelle, pour être finalement inséré ; il contient le dispositif d'alimentation pneumatique correspondant pour entraîner le fil de fer jusqu'à l'extrémité opposée de la tête d'insertion, pour que celle-ci, dotées des mâchoires correspondantes, puisse effectuer une première opération de conformation des extrémités du fil de fer, mais sans aller jusqu'à le couper, celui-ci poursuivant jusqu'à une conduite ou guide qui le mène à un disque, dont l'intérieur est muni de la rainure correspondante qui, à son tour, et d'une façon connue, par giration, procède à la séparation de chaque morceau de fiche déjà conformée du reste du fil de fer, suivant ensuite, également d'une façon connue, la descente d'un poinçon conventionnel, pour, au travers de la bouche correspondante, procéder à l'insertion de cette fiche dans le circuit imprimé correspondant, situé au-dessus de la table de coordonnées ou plateau correspondant.

Dans cette réalisation, les cylindres pneumatiques et hydrauliques qui entraînent l'ensemble de la tête d'insertion sont réduits à deux, le premier d'entraînement du fil de fer provenant de la bobine et monté sur la machine à insérer, à l'aide du support correspondant, pour l'introduire dans la partie intérieure de la tête proprement dite, jusqu'à la placer près des mâchoires, tel que cela a déjà été commenté, et le second d'entre eux qui agit sur la came correspondante, celle-ci actionnant un glisseur pour pousser le poinçon et procéder à l'opération d'insertion proprement dite.

D'autres détails et caractéristiques de l'actuelle patente d'invention seront soulignés au cours de la description qui est donnée ci-dessous, et qui fait référence aux figures accompagnant ce mémoire dans lequel, de façon quelque peu schématique, sont représentés les détails préférés. Ces détails sont donnés à titre d'exemple et se réfèrent à un cas possible de réalisation pratique, mais ne demeurent pas limités aux détails qui y sont exposés ; cette description doit donc être considérée d'un point de vue illustratif et sans aucune sorte de limitations.

Nous établirons ci-dessous les divers éléments numérotés sur les dessins joints au présent mémoire : (10) tête d'insertion, (11) mâchoire, (12) pointes, (13) jeu de redresseurs, (14) dispositif d'alimentation pneumatique, (15) conduite, (16) embouchure, (17) conduite de guidage, (18) fiche, (19) disque, (20) rainure, (21) dispositif de rétention, (22) circuit imprimé, (23) plateau, (24) poinçon, (25) cylindre pneumatique ou hydraulique, (26) came, (26a) axe de giration de la came (26), (27) couronne, (27a) axe de rotation de la couronne, (28) poussoir, (29) labyrinthe, (30) corps, (31) bouche d'alimentation, (32) conduite, (33) axe, (34) tige, (35) axe, (36) dispositif, (37) couronne, (37a) périmètre, (38) protubérances, (39) extrémités de (11), (40) bras, (41) goupilles.
La figure n° 1 est une vue frontale en élévation sectionnée longitudinalement de l'ensemble de la tête d'insertion (10), qui est elle-même formée de deux corps distincts, le premier situé sur la gauche et qui canalise le fil de fer au travers d'un jeu de redresseurs (13) et au moyen d'un dispositif d'alimentation pneumatique (14) le place près de l'embouchure (16) ; un autre corps situé sur la droite et dont la fonction est celle d'insertion pneumatique, formé de dispositifs d'entraînement du poinçon (24), agit sur la fiche (18), pour la laisser enfoncée dans le circuit imprimé (22).
La figure n° 2 est une vue postérieure de la tête (10), selon la figure n° 1, sur laquelle on peut voir le système d'entraînement et de giration du disque (19), à l'aide du poussoir (28) et du bras (40).
La figure n° 3 est une section partielle transversale de l'un des corps de la tête (10).

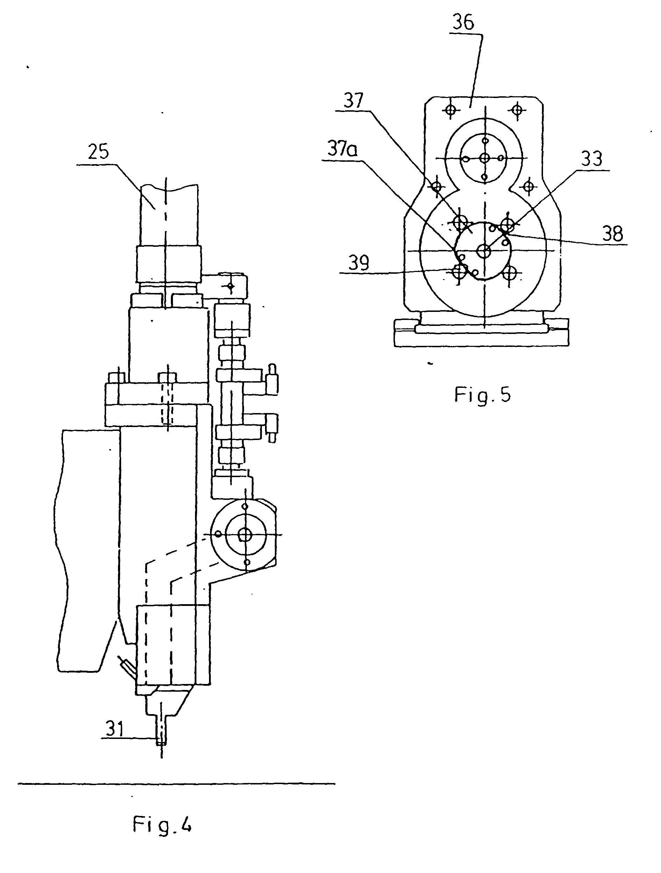

La figure n° 4 est une vue en élévation latérale de l'un des corps de la tête (10).
La figure n° 5 est une section transversale en élévation du dispositif (36) qui agit sur les mâchoires (11).

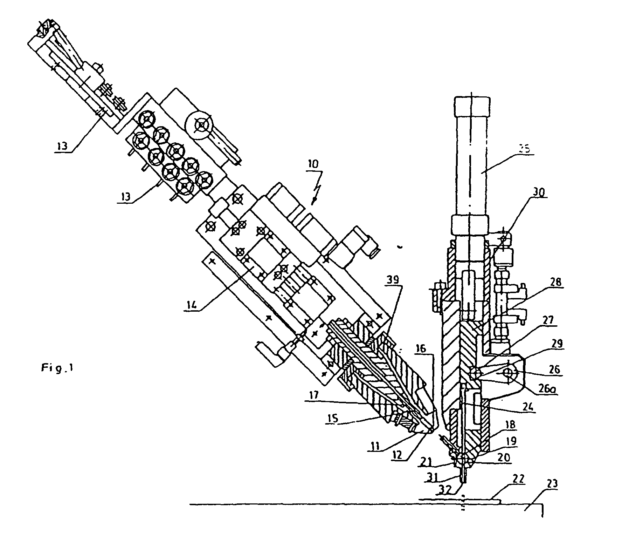

Dans l'une des réalisations préférées de ce qui fait l'objet de la présente sollicitude de patente d'invention, comme le montre la figure n° 1, la tête d'insertion (10) est formée de deux corps ; le premier d'entre eux est représenté de façon inclinée sur la partie gauche de la figure et sa fonction est celle de redresser et d'alimenter en fil de fer le dispositif d'insertion proprement dit, cependant que le second, qui est représenté sur la partie droite de la figure, en position verticale, a pour mission de couper le fil de fer une fois pré-traité par le corps antérieur, de le séparer du reste du fil de fer et de procéder à l'enfoncement ou insertion de la fiche dans le circuit imprimé (22) correspondant situé sur le plateau (23).

Le corps situé sur la gauche de la tête (10) est formé par un jeu de redresseurs (13) formés de rouleaux conventionnels, chaque jeu étant situé à 90° l'un par rapport à l'autre ; son but est de faire passer le fil de fer fourni par une bobine conventionnelle adaptée au moyen d'un support de la machine à insérer et de l'obliger à avancer vers la partie supérieure de la tête, à l'aide d'un dispositif d'alimentation pneumatique (14) qui le soutient et réalise une tâche de traction, servant à faire avancer le fil de fer et à dépasser la force de friction qu'implique le jeu de redresseurs (13), ce qui fait que, à part le faire avancer, il collabore à la fonction de redressement proprement dite.

L'action en continu du dispositif d'alimentation (14) qui saisit, par les moyens connus, le fil de fer et le fait avancer vers l'embouchure (16), l'introduit par la conduite (15) jusqu'à le placer en alignement avec les pointes (12) des mâchoires (11) qui s'ouvrent et se ferment en combinaison avec le dispositif (36) qui sera décrit plus avant, voir la figure n° 5, ces pointes (12) produisant des lignes ou périmètres de fente sur la tige qui passe entre elles. La tige poursuivant son parcours jusqu'à se trouver en position dans la conduite de guidage (17), voir la figure n° 1, à ce moment-là, le disque (19) se trouve muni de la rainure (20), aligné avec (17), tournant ensuite, grâce à l'action du bras (40) et le poussoir (28), brisant et séparant la fiche (18) par le point faible du fil de fer fourni par la tête, l'alignant sur le poinçon (24) qui, lui, par l'action du cylindre (25) pousse (24) d'une façon connue, enfonçant la fiche (18) dans le circuit imprimé (22). La fonction du dispositif (36) est de servir de moyen d'entraînement des mâchoires (11), lesquelles, au travers de leurs extrémités (39) sont obligées de tourner de l'intérieur vers l'extérieur et vice versa, par l'action de la couronne (37) dotée du périmètre (37a), et de tourner sur l'axe (33). Le périmètre (37a) de la couronne (37) présente à des distances régulières des protubérances (38) qui déplacent les extrémités (39) des mâchoires (11), obligeant les pointes (12) situées sur les parties intérieures de (11) à produire des fentes sur toute la section transversale de la tige en parcourant celle-ci.

Le caractère approprié du dispositif (36) permet, avec un simple changement de couronne (37) d'axe (33), de réguler le parcours de ces mâchoires (11) et permettre ainsi de travailler également avec différents diamètres de fil de fer ou tige pour la formation de fiches, sans que cela ne suppose non plus de changement de tête pour travailler sur d'autres largeurs de tiges, ce qui confère une meilleure versatilité à la tête d'insertion préconisée.

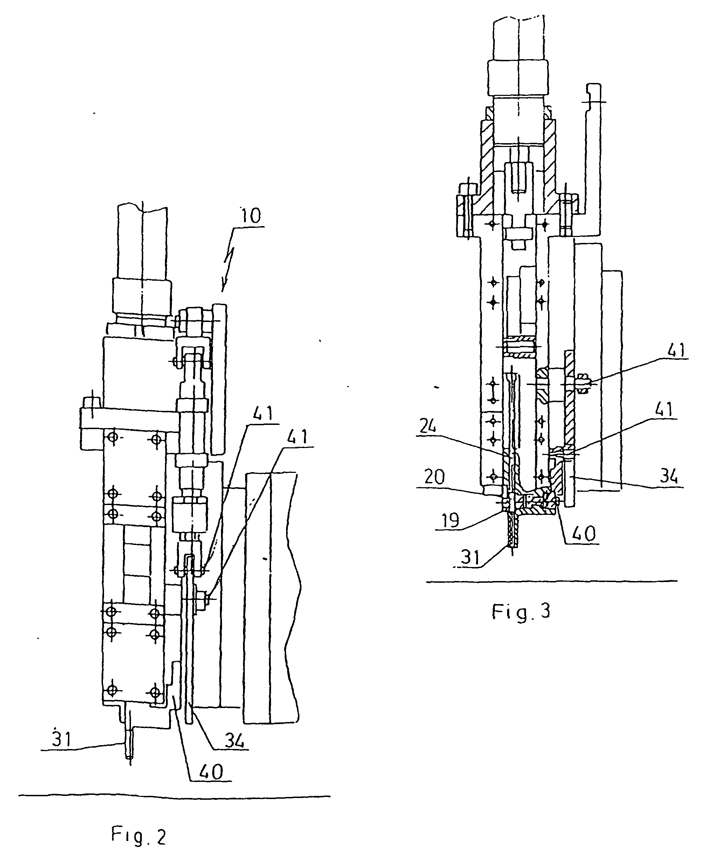

En outre, un autre objet d'invention consiste, tel que cela est expliqué dans la partie antérieure du mémoire, en la possibilité que la tête décrite permette, en plus des fonctions susmentionnées, de travailler avec différentes longueurs de fiches (18), ce qui, en combinaison avec la possibilité de certaines machines à insérer de travailler avec plusieurs circuits (22) de différentes dimensions, ajoute un nombre infini de possibilités rentabilisant ce type de machines; tout cela étant obtenu grâce au dispositif formé à la base, comme l'indique la figure n° 1, de la came (26) laquelle tourne autour de l'axe (26a), une couronne (27) ayant été prévue sur l'extrémité de cette came (26) dont la surface extérieure cylindrique agit sur le poussoir (28) lequel, grâce à la configuration spéciale du labyrinthe (29), permet différents parcours du poinçon (24), lequel se charge, d'une façon connue, d'enfoncer la fiche (18) dans le circuit (22), lorsque la contre-bouterolle correspondante, qui n'est pas représentée sur les figures, se trouve au-dessous de ce dernier. Le poinçon (24), par l'action du cylindre (25), pousse la fiche (18) qui se trouve dans la rainure (20), voir la figure n° 3, et le fait ressortir par la bouche d'alimentation (31), le parcours du dispositif d'alimentation (14) et son parcours vers le bas dépendant de la plus grande longueur de la fiche (18), grâce au déplacement imprimé par la came (26) sur le poussoir (28), ce qui fait que ce poinçon (24) effectue sa course en poussant la fiche (20) située dans ladite rainure (20), ce dernier, une fois séparé de la tige à partir de laquelle est conformée la fiche, est maintenu par le dispositif de rétention (21) jusqu'à ce que celui-ci se retire et que le poinçon (24) agisse par l'action dudit poussoir (28) de la manière décrite. Comme l'indiquent les figures n° 2 et 3, le mouvement du disque (19) se produit au travers du bras (40), lequel se trouve uni à la tige (34) à l'aide des goupilles (41). La coordination entre les éléments qui entraînent la giration du disque (19), eux-mêmes coordonnés avec celui du dispositif d'alimentation pneumatique (14) et le dispositif (36) qui permet l'ouverture et la fermeture des mâchoires (11), afin que lorsque les pointes (20) auront produit la fente dans la tige ou fil de fer correspondant, et que celui-ci aura été poussé à l'intérieur de la conduite de guidage (17), la rainure (20) se trouve alignée avec (17) pour recevoir la fiche (18) semi-élaborée ; par l'action de la giration de ce disque (20), elle est séparée du reste de la tige et avec des cycles opératifs analogues à la description, le cycle opératif de la tête d'insertion se poursuivant.

Le changement de fiches (18) de différentes longueurs et la coordination des mouvements susmentionnés ne mènera qu'à obliger le poinçon (24) à se déplacer à une distance plus ou moins grande en fonction de la plus ou moins grande longueur d'inertie de la fiche (18) à insérer dans le circuit (22).

La présente patente d'invention ayant été suffisamment décrite en correspondance avec les plans ci-joints, il est entendu que toutes modifications de détail jugées opportunes pourront être introduites sur ceux-ci, dans les limites de la protection définie par les REVENDICATIONS suivantes.

## Revendications

1. "Une tête d'insertion de fiches de différentes longueurs" qui est formée par deux corps, le premier d'entre eux possède des moyens d'alimentation d'une tige, des moyens de redressement de cette tige et des moyens d'entraînement de celle-ci, jusqu'à la situer entre les pointes (12) de mâchoires (11), cependant que le second corps incorpore des moyens de création de fiches et insère celles-ci dans des circuits imprimés (22) situés dans des plateaux (23) de tables de coordonnées de machines à insérer, **se caractérisant par le fait que** la tête d'insertion (10) agit sur un poinçon (24) par le biais de moyens pneumatiques en permettant de multiples courses du poinçon (24), de différentes longueurs, conformément aux longueurs des fiches (18) à insérer sur des circuits imprimés (22) et parce que les distances parcourues par le poinçon (24) sont déterminées par la longueur de la fiche (18) grâce à une came (26) en tournant par des moyens hydrauliques ou pneumatiques autour d'un axe (26a) et une couronne (27) avec un axe de giration (35) actionnant un poussoir (28) ayant été prévue sur l'extrémité de cette came (26), le poussoir fait que le poinçon (24) effectue sa course en poussant la fiche.

2. "Une tête d'insertion de fiches de différentes longueurs" **caractérisée** selon la revendication 1 par le fait que la couronne (27) travaille en combinaison avec le labyrinthe (29) du poussoir (28).

## Patentansprüche

1. "Bestückungskopf für Stecker verschiedener Längen", der aus zwei Körpern bestehen, von denen ersterer mit Versorgungsmitteln eines Stäbchens ausgestattet ist, mit Mitteln für das Ausrichten dieses Stäbchens und Mitteln zur Mitnahme desselben, bis dieses zwischen den beiden Spitzen (12) der Greifbacken (11) zu liegen kommt, während der zweite Körper Mittel zur Herstellung von Steckern aufweist und diese in Leiterbahnen (22) auf Platten (23) von Koordinatentischen von Bestückungsmaschinen einfügt, **dadurch gekennzeichnet, dass** der Bestückungskopf (10) mit pneumatischen Mitteln auf einen Stempel (24) einwirkt, und so eine Vielzahl von verschieden langen Hüben (24) ermöglicht, entsprechend der Längen der Stecker (18), mit denen die Leiterbahnen (22) zu bestücken sind, und dass die von Stempel (24) zurückgelegten Hübe durch die Länge des Steckers (18) über eine Nocken (26) festgelegt werden, indem dieser durch hydraulische oder pneumatische Mittel um eine Achse (26a) und eine Kranz (27) mit einer Drehachse (35) dreht, die einen Drücker (28) betätigt, welcher am Ende dieses Nockens (26) vorgesehen ist, und der Drücker bewirkt, dass der Stempel (24) ihre Hub unter Drücken der Steckern durchführt.

2. "Bestückungskopf für Stecker verschiedener Längen" nach Anspruch 1, **dadurch gekennzeichnet, dass** dass der Kranz (27) mit dem Labyrinth (29) des Drückers (28) zusammenwirkt.

## Claims

1. An insertion head for inserting components of different lengths formed by two bodies, the first of these having means of feeding a rod, means of straightening this rod and means of dragging the rod, until placing it between the ends (12) of the clamps (11), whereas the second body incorporates means of creating components and inserts them into printed circuits (22) located on boards (23) of insertion machine coordinate tables, **characterised in that** the insertion head (10) acts on the punch (24) by means of pneumatic means allowing multiple runs of (24), of different lengths, according to the lengths of the components (18) which must be inserted in the printed circuits (22), and **in that** the distances covered by the punch (24) are determined by means of the length of the component (18) thanks to a cam when turning by means of hydraulic or pneumatic means about a shaft (26a) and a ring (27) with a rotating shaft (35) actuating a push rod (28) provided on the end of this cam (26), the push rod making the punch (24) carry out its run, pushing the component.

2. An insertion head for inserting components of different lengths according to claim 1, **characterised in that** the ring (27) works in combination with the coil (29) of the push rod (28).
